# EUROPEAN PATENT SPECIFICATION

(11) **EP 2 897 139 B1**
(45) Date of publication and mention of the grant of the patent: **11.10.2017**
(21) Application number: 14275267.4
(22) Date of filing: 24.12.2014
(51) Int. Cl.: H01F 1/37, H01F 27/36, H01F 38/14, H01F 1/047, H01F 27/245, H01F 27/28

(54) **Method of manufacturing a composite ferrite sheet.**
Verfahren zur Herstellung eines verbundenen Ferritblechs.
Procédé de fabrication d'une feuille de ferrite composite.

(30) Priority: 15.01.2014 KR 20140004940
(43) Date of publication of application: 22.07.2015
(73) Proprietor: Samsung Electro-Mechanics Co., Ltd., Suwon-Si, Gyeonggi-Do (KR)
(72) Inventor: Han, Chang Mok, Gyeonggi-Do (KR); Chang, Ki Won, Gyeonggi-Do (KR); Cho, Sang Ho, Gyeonggi-Do (KR); Park, Sung Heum, Gyeonggi-Do (KR); Cho, Hyung Wook, Gyeonggi-Do (KR); Han, Jeong Man, Gyeonggi-Do (KR)
(74) Representative: Potter Clarkson LLP

(56) References cited:
- EP-A1- 1 262 466
- EP-A1- 1 453 368
- US-A- 6 063 511
- US-A1- 2004 211 580
- US-A1- 2011 210 696

## Description

### CROSS-REFERENCE TO RELATED APPLICATION

This application claims the benefit of Korean Patent Application No. 10-2014-0004940, filed on January 15, 2014, with the Korean Intellectual Property Office.

### BACKGROUND

The present disclosure relates to a method of manufacturing a composite ferrite sheet, providing improved shielding performance.

In accordance with recent improvements in the area of information technology (IT), portable devices such as smartphones have become available and are actively being used on the global level.

Therefore, a wireless charging apparatus for charging such portable devices with power has been developed. Demand for magnetic sheets, commonly included in such wireless charging apparatuses, has increased.

The magnetic sheets may be disposed in the portable device to perform various roles such as the blocking of electromagnetic waves, the forming of paths for magnetic flux formed by antenna sheets or coils, and the like.

In accordance with the thinning of such portable devices, ferrite sheets have been gradually thinned. However, in the case that ferrite sheets are thinned as described above, a magnetic field generated in the coil may not be able to be contained thereby, such that an amount of leaked magnetic field may be increased.

Therefore, a ferrite sheet capable of containing an entirety of a magnetic field therein, while being maintained to be relatively thin, has been demanded.

### [Related Art Document]

(Patent Document 1) Korean Patent Laid-Open Publication No. 10-2013-0082324

US 2011/210696 A1 discloses a contactless power receiving apparatus having a spiral power receiving coil; a rectifier; a secondary battery; an electronic device supplied with direct voltage from the secondary battery. A composite magnetic body is located between the secondary battery and the spiral coil, and between the electronic device and the spiral coil. The composite magnetic body includes first and other layers of magnetic sheets through an insulating layer in which when a relative magnetic permeability of the first magnetic sheet provided to a side of the spiral coil is µd, a thickness of the first magnetic sheet is tu, an average relative magnetic permeability of the other magnetic sheets other than the first magnetic sheet is µu, and a total thickness of the other magnetic sheets is tu, the composite magnetic body satisfies the following relations: µd·td≦60 [mm]; and µu·tu≧100[mm].

US 2004/211580 A1 discloses a shielded assembly comprising a substrate and, disposed above the substrate, a shield. The shield is made of a nanomagnetic material which has a saturation magnetization of from about 1 to about 36,000 Gauss (1 Gauss = 0.0001 Tesla), a coercive force of from about 0.01 to about 5000 Oersteds (1 Oersted = 10³/4π A/m), a relative magnetic permeability of from about 1 to about 500,000, and an average particle size of less than about 200 nanometers.

### SUMMARY

An aspect of the present disclosure may provide a composite ferrite sheet capable of increasing capability of containing a magnetic field while being maintained at a relatively thin thickness and an electronic device including the same.

An aspect of the present invention provides a method of manufacturing a composite ferrite sheet by which the composite ferrite sheet may be easily manufactured.

According to an example of the present disclosure, a composite ferrite sheet may include: a ferrite sheet; and composite sheets attached to both surfaces of the ferrite sheet, respectively, and having insulating properties.

The composite sheet may be formed of a resin containing metal powder particles.

In the composite sheet, the metal powder particles may be formed to be flake-shaped.

All of the ferrite sheet and the composite sheets may be formed to have the same thickness.

The ferrite sheet may contain NiZnCu or MnZn.

The metal powder particles may include at least any one of a sendust-based metal, a Permalloy-based metal, and an amorphous metal.

According to an aspect of the present invention, a method of manufacturing a composite ferrite sheet includes: preparing a ferrite sheet; and forming composite sheets having insulating properties on both surfaces of the ferrite sheet, respectively.

The forming of the composite sheets includes: supplying slurry for the composite sheets to the ferrite sheet; applying the slurry to both surfaces of the ferrite sheet; and rolling the ferrite sheet and the slurry, to press and bond the slurry to both surfaces of the ferrite sheet.

In the rolling of the slurry and the ferrite sheet, at least one or more rollers may be used.

The slurry for the composite sheets may be formed of a resin containing metal powder particles.

The forming of the composite sheets may include: stacking the composite sheets on the ferrite sheet, respectively; and integrating the composite sheets with the ferrite sheet by compressing the composite sheets.

The integrating of the composite sheets with the ferrite sheet may include applying heat to the composite sheets to thermally compress the composite sheets.

The integrating of the composite sheets with the ferrite sheet may include interposing an adhesive sheet between the composite sheets and the ferrite sheet.

The forming of the composite sheets may include applying a solution for the composite sheets to the ferrite sheet using a spraying scheme.

The method of manufacturing a composite ferrite sheet may further include cutting the ferrite sheet having the composite sheets formed on both surfaces thereof, respectively.

According to another aspect of the present invention, a method of manufacturing a composite ferrite sheet includes: supplying a ferrite sheet to a space between rollers; supplying slurry for a composite sheet to both surfaces of the ferrite sheet, before the ferrite sheet enters the space between the rollers; and applying the slurry to the ferrite sheet and compressing the slurry using the rollers.

According to another example of the present disclosure, an electronic device for wireless charging may include: a coil part having coil patterns formed thereon; and a composite ferrite sheet coupled to one surface of the coil part and including a ferrite sheet and composite sheets formed on both surfaces of the ferrite sheet, respectively.

The composite sheets may be formed of a resin containing metal powder particles having a flake shape.

### BRIEF DESCRIPTION OF DRAWINGS

The above and other aspects, features and other advantages of the present disclosure will be more clearly understood from the following detailed description taken in conjunction with the accompanying drawings, in which:
FIG. 1 is a perspective view schematically illustrating an electronic device and a wireless charging apparatus according to an exemplary embodiment in the present disclosure;
FIG. 2 is a cross-sectional view taken along the line A-A' of FIG. 1;
FIG. 3 is a cross-sectional view schematically illustrating composite ferrite sheets according to an exemplary embodiment in the present disclosure;
FIG. 4 is a graph schematically illustrating efficiency characteristics of a composite ferrite sheet according to an exemplary embodiment in the present disclosure;
FIG. 5 is a flow chart illustrating a method of manufacturing a composite ferrite sheet according to an exemplary embodiment in the present disclosure;
FIG. 6 is a view illustrating the method of manufacturing the composite ferrite sheet of FIG. 5;
FIG. 7 is a flow chart illustrating a method of manufacturing a composite ferrite sheet according to another exemplary embodiment in the present disclosure;
FIG. 8 is a view illustrating the method of manufacturing the composite ferrite sheet of FIG. 7;
FIG. 9 is a flow chart illustrating a method of manufacturing a composite ferrite sheet according to another exemplary embodiment in the present disclosure; and
FIG. 10 is a view illustrating the method of manufacturing the composite ferrite sheet of FIG. 9.

### DETAILED DESCRIPTION

Hereinafter, embodiments in the present disclosure will be described in detail with reference to the accompanying drawings.

The disclosure may, however, be embodied in many different forms and should not be construed as being limited to the embodiments set forth herein. Rather, these embodiments are provided so that this disclosure will be thorough and complete, and will fully convey the scope of the disclosure to those skilled in the art.

In the drawings, the shapes and dimensions of elements may be exaggerated for clarity, and the same reference numerals will be used throughout to designate the same or like elements.

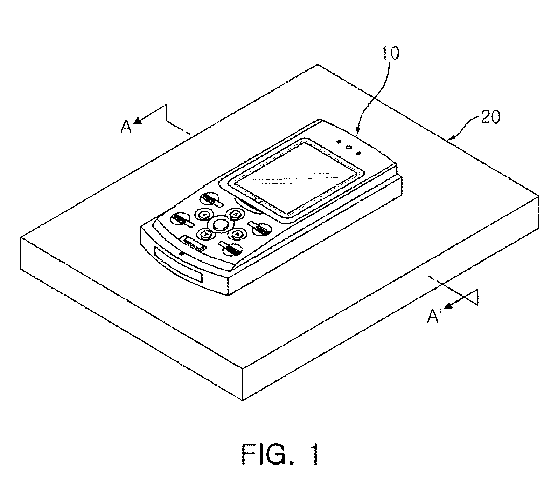

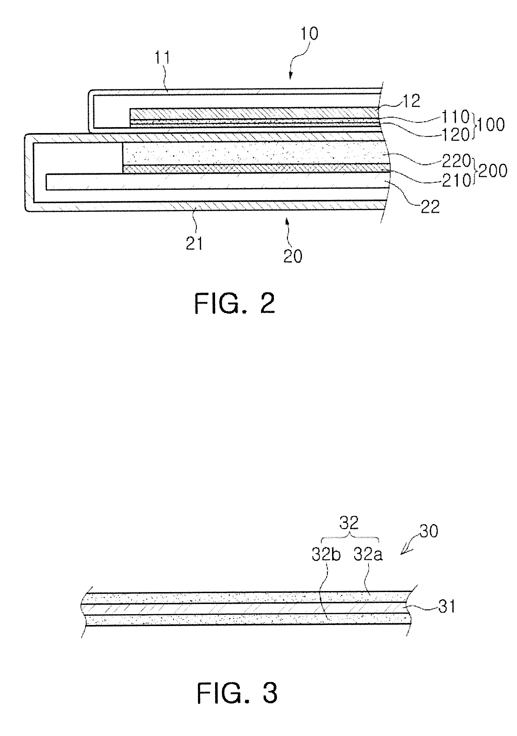

FIG. 1 is a perspective view schematically illustrating an electronic device and a wireless charging apparatus according to an exemplary embodiment in the present disclosure; and FIG. 2 is a cross-sectional view taken along the line A-A' of FIG. 1.

Referring to FIGS. 1 and 2, an electronic device 10 according to the present exemplary embodiment may include a battery 12 and a contactless power receiving apparatus 100 supplying power to the battery 12 to charge the battery 12 with power.

The battery 12 may be a secondary battery that is rechargeable and may be configured so as to be detachable from the electronic device 10.

The contactless power receiving apparatus 100 may be accommodated in a case 11 of the electronic device 10. The contactless power receiving apparatus 100 may be directly attached to an inner surface of the case 11 or may be disposed so as to be as close to the inner surface of the case 11 as possible.

In addition, the wireless charging apparatus 20 according to the present exemplary embodiment may be provided in order to charge the battery 12 of the electronic device 10 with power. To this end, the wireless charging apparatus 20 may include a contactless power transmitting apparatus 200 disposed in a case 21.

The wireless charging apparatus 20 may convert alternating current (AC) power to direct current (DC) power, convert the DC power into an AC voltage having a specific frequency, and supply the AC voltage to the contactless power transmitting apparatus 200. To this end, the wireless charging apparatus 20 may include a power converting unit 22 converting the AC power into the AC voltage having the specific frequency.

When the AC voltage having the specific frequency is applied to a coil of the contactless power transmitting apparatus 200, a magnetic field around the coil may be changed. Therefore, the contactless power receiving apparatus 100 of the electronic device 10 disposed adjacently to the contactless power transmitting apparatus 200 may have a voltage applied thereto depending on the change in the magnetic field. As a result, the battery 12 may be charged with power.

The electronic device 10 and the wireless charging apparatus 20 according to the present exemplary embodiment configured as described above may include the contactless power receiving apparatus 100 and the contactless power transmitting apparatus 200, respectively. In addition, the contactless power receiving apparatus 100 and the contactless power transmitting apparatus 200 may include coil parts 120 and 220 and magnetic parts 110 and 210, respectively.

The coil parts 120 and 220 may be formed to have, for example, but not limited to, a flat plate shape or a sheet shape in which coil patterns are formed therein or may be formed in a form such as a printed circuit board, a flexible board, a film, or the like. Here, the coil pattern may be formed as a wiring pattern.

However, the present disclosure is not limited thereto, but may be variously modified. For example, the coil parts 120 and 220 may be formed using wires, if necessary.

The magnetic parts 110 and 210 may be provided in order to efficiently form magnetic paths of magnetic fields generated by the coil parts 120 and 220.

To this end, the magnetic parts 110 and 210 according to the present exemplary embodiment may be formed to have a flat plate shape (or a sheet shape). The magnetic parts 110 and 210 may be fixed and/or attached to each surfaces of the coil parts 120 and 220.

The magnetic parts 110 and 210 may be formed of a material that may easily form the magnetic path, for example, but not limited to, a sheet having magnetic permeability, such as a ferrite sheet, a metal composite sheet, an amorphous sheet, or the like.

Particularly, the magnetic parts 110 and 210 according to the present exemplary embodiment may be formed of a composite ferrite sheet formed by stacking a composite sheet and a ferrite sheet.

FIG. 3 is a cross-sectional view schematically illustrating a composite ferrite sheet according to an exemplary embodiment in the present disclosure.

A composite ferrite sheet 30 according to the present exemplary embodiment may include a ferrite sheet 31 disposed in the center of the composite ferrite sheet 30 and composite sheets 32 attached to both surfaces of the ferrite sheet 31, respectively.

Various ferrite sheets known in the related art may be used for the ferrite sheet 31. For example, the ferrite sheet 31 according to the present exemplary embodiment may be manufactured by preparing slurry containing ferrite to form green sheets and then sintering the green sheets. However, the present disclosure is not limited thereto.

The ferrite sheet 31 may have wide magnetic permeability having a frequency band of 100KHz to 13.56MHz and may also have high magnetic permeability. However, in the case in which the ferrite sheet 31 is manufactured to be relatively thin, it may be difficult to completely block a magnetic field from being leaked to the outside of the composite ferrite sheet 30.

The ferrite sheet 31 according to the present exemplary embodiment may contain, for example, but not limited to, NiZnCu, MnZn, or the like.

The composite sheet 32 may be formed by mixing metal powder particles (for example, iron, aluminum, silicon, cobalt, zinc, chrome, or the like) with a resin.

As the resin mixed in the composite sheet 32, various resins or insulating materials that have insulating properties and may contain metal powder particles, such as various polymer resins, acryl resins, or the like, may be used.

The metal powder particles comprised in the composite sheet 32 may be formed to have a flat flake shape.

In the case in which the metal powder particles are formed to have the flat flake shape, the metal powder particles may be disposed so as to be substantially parallel to a surface direction of the composite sheet 32 within the composite sheet 32. In this case, magnetic flux may be formed in spaces between the metal powder particles disposed parallel to each other.

Particularly, the metal powder particles of the composite sheet 32 according to the present exemplary embodiment may include at least one of a sendust (Fe-Si-Al-alloy)-based metal, a Permalloy-based metal, and an amorphous metal, but are not limited thereto.

The composite sheet 32 according to the present exemplary embodiment may be formed of a sheet that contains metal powder particles, but generally has insulating properties. In the case in which the composite sheet 32 is formed of a conductive material, the composite sheet 32 may block a flow of magnetic flux, such that efficiency may be decreased.

In addition, in the composite ferrite sheet 30 according to the present exemplary embodiment, at least three sheets including the ferrite sheet 31 and the composite sheets 32 may be formed to have the same thickness or a similar thickness.

Further, in the composite ferrite sheet 30 according to the present exemplary embodiment, an adhesive sheet allowing the ferrite sheet 31 and the composite sheet 32 to adhere to each other may not be needed. This may be possible since the composite sheet 32 according to the present exemplary embodiment may be formed of a material including a resin.

For instance, molten liquid resins may be directly applied to the ferrite sheet 31 and be then hardened, whereby the composite sheets 32 may be directly attached to both surfaces of the ferrite sheet 31, respectively, without using a separate adhesive sheet. Here, the resin may be a polymer resin, but is not limited thereto.

In the case in which the ferrite sheet 31 according to the present exemplary embodiment has a thickness of 0.1mm, each of the composite sheets 32a and 32b may be formed to have a thickness of 0.1mm. Therefore, the composite ferrite sheet 30 may be generally formed to have a thickness of approximately 0.3mm.

In the case in which the adhesive sheet is interposed, the thickness of the composite ferrite sheet 30 may be further increased. However, in the composite ferrite sheet 30 according to the present exemplary embodiment, the adhesive sheet may be omitted as described above, and thus, a thickness of the ferrite sheet 31 or the composite sheet 32 may be further secured or the composite ferrite sheet 30 may be manufactured in a generally thin form.

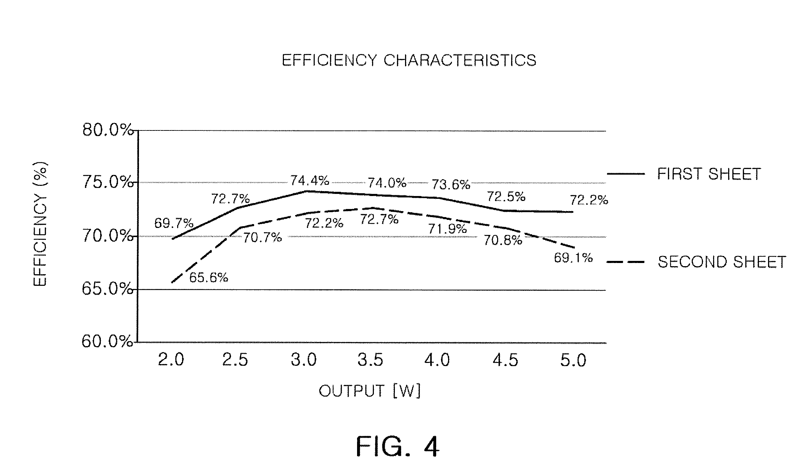

FIG. 4 is a graph schematically illustrating efficiency characteristics of a composite ferrite sheet according to an exemplary embodiment in the present disclosure.

In FIG. 4, a "first sheet" indicates a composite ferrite sheet in which the composite sheet 32 is attached to only one surface of the ferrite sheet 31, and a "second sheet" indicates that a composite ferrite sheet in which the composite sheets 32 are attached to both surfaces of the ferrite sheet 31. FIG. 4 is a graph in which magnetic field shielding efficiencies of the first sheet and the second sheet are measured and compared with each other.

In the first sheet, the ferrite sheet 31 and the composite sheet 32 are attached to each other through an adhesive sheet, and a coil part is disposed on the other surface of the ferrite sheet 31. In addition, in the present exemplary embodiment, the magnetic field shielding efficiency may mean an efficiency of an output that may be obtained by shielding magnetic flux leaked to the outside of the composite ferrite sheet 30 and concentrating the magnetic flux on an inner portion of the composite ferrite sheet 30.

Referring to FIG. 4, the magnetic field shielding efficiency of the second sheet may be higher than the first sheet.

In the case of the first sheet, the adhesive sheet may be interposed as described above. Therefore, a thickness of the first sheet may substantially correspond to that of the second sheet. Therefore, the second sheet may provide more efficiency than the first sheet in spite of having a thickness similar to that of the first sheet.

Next, a method of manufacturing a composite ferrite sheet 30 according to an exemplary embodiment in the present disclosure will be described.

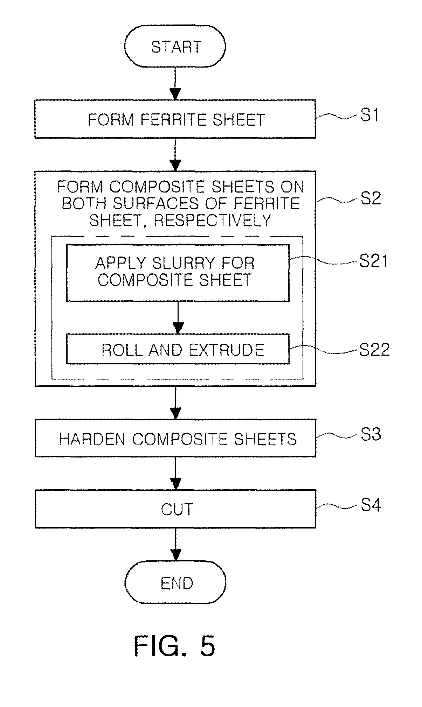

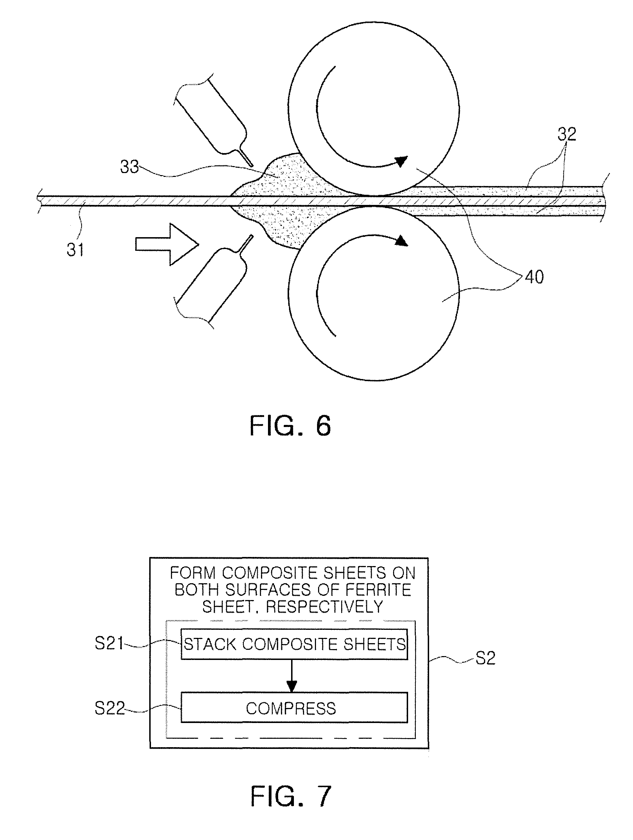

FIG. 5 is a flow chart illustrating a method of manufacturing the composite ferrite sheet 30 according to an exemplary embodiment in the present disclosure; and FIG. 6 is a view illustrating the method of manufacturing the composite ferrite sheet 30 of FIG. 5.

Referring to FIGS. 5 and 6, in the method of manufacturing the composite ferrite sheet 30 according to the present exemplary embodiment, the ferrite sheet 31 may be prepared first (S1). The ferrite sheet 31 may be manufactured by various methods known in the art. For example, the ferrite sheet 31 may be manufactured by preparing slurry containing ferrite to form green sheets, stacking and compressing the green sheets, and then sintering the green sheets. However, the present disclosure is not limited thereto.

Then, the composite sheets 32 may be formed on both surfaces of the ferrite sheet 31, respectively (S2). In the operation (S2), slurry 33 for the composite sheets 32 may be applied onto both surfaces of the ferrite sheet 31 (S21).

In the present exemplary embodiment, a material of the composite sheet 32 having the form of the slurry 33 may be prepared and then applied to both surfaces of the ferrite sheet 31. The material of the composite sheet 32 having the form of the slurry 33 may be formed by containing metal powder particles in a liquid resin.

For example, according to an aspect of the present invention, in the operation of applying the slurry 33, rollers 40 are used, as illustrated in FIG. 6. That is, at least two rollers 40 may roll while being engaged with each other, and the ferrite sheet 31 is supplied between the rollers 40.

In addition, before the ferrite sheet 31 enters between the rollers 40, the slurry 33 is supplied to the ferrite sheet 31.

The slurry 33 may be applied to both surfaces of the ferrite sheet 31 and then be pressed together with the ferrite sheet 31 using the rollers 40 (S22). Here, the slurry 33 may contain the resin as a main component, and therefore, the slurry 33 may be easily applied and bonded to the ferrite sheet 31. In addition, the metal powder particles contained in the slurry 33 may have the flake shape. Further, the metal powder particles may be disposed in the composite sheet 32 in the form in which they are substantially parallel to the ferrite sheet 31 using the rollers 40.

Then, the composite sheets 32 may be hardened (S3). The composite ferrite sheet 30 in which the composite sheets 32 are hardened may be cut so as to have a required size (S4) to manufacture the composite ferrite sheet 30 according to the present exemplary embodiment.

As described above, in the method of manufacturing the composite ferrite sheet 30 according to the present exemplary embodiment, the melted resin, for example, but not limited to, the slurry 33 may be directly applied to the ferrite sheet 31 and may be then hardened, whereby the composite sheets 32 may be directly attached to both surfaces of the ferrite sheet 31, respectively, without using a separate adhesive sheet.

Therefore, since a process of attaching the adhesive sheet may be omitted, the composite ferrite sheet may be easily manufactured, while time and costs required for manufacturing the composite ferrite sheet may be decreased.

The method of manufacturing a composite ferrite sheet according to the present disclosure is not limited to the exemplary embodiments described above, but may be variously modified.

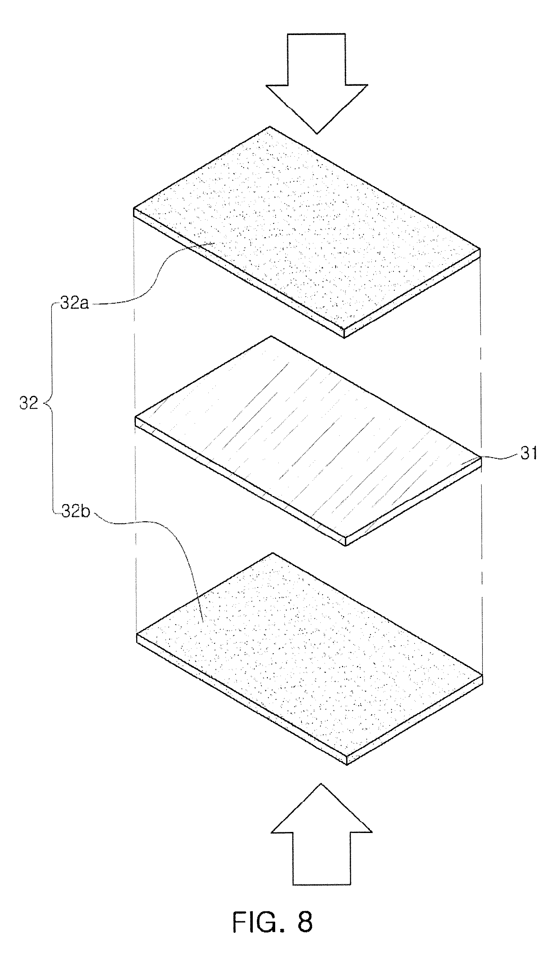

FIG. 7 is a flow chart illustrating a method of manufacturing a composite ferrite sheet according to another exemplary embodiment in the present disclosure; and FIG. 8 is a view illustrating the method of manufacturing the composite ferrite sheet of FIG. 7.

The method of manufacturing a composite ferrite sheet according to the present exemplary embodiment may be similar to the method of manufacturing the composite ferrite sheet according to the exemplary embodiment in the present disclosure described above, and may be different in an operation (S2) of forming composite sheets on both surfaces of a ferrite sheet, respectively, from the method of manufacturing the composite ferrite sheet according to the exemplary embodiment in the present disclosure described above. Therefore, a description for the same operations as those of the method of manufacturing the composite ferrite sheet according to the exemplary embodiment in the present disclosure described above will be omitted, and the operation (S2) will be described in detail.

Referring to FIGS. 7 and 8, in the method of manufacturing the composite ferrite sheet 30 according to the present exemplary embodiment, the operation (S2) of forming the composite sheets 32 on both surfaces of the ferrite sheet 31, respectively, may include an operation (S21) of stacking the composite sheets 32 on both surfaces of the ferrite sheet 31, respectively, and a compressing operation (S22).

That is, in the method of manufacturing the composite ferrite sheet according to the present exemplary embodiment, after the composite sheets 32 are prepared in advance, the composite sheets 32 may be stacked on both surfaces of the ferrite sheet 31, respectively, and may be compressed to be formed integrally with the ferrite sheet 31.

Here, in the compressing process (S22), heat may be applied to the composite sheets 32 so that the composite sheets 32 containing a resin component may be firmly attached to the ferrite sheet 31, whereby the composite sheets 32 may be thermally compressed.

Meanwhile, various applications may be made. For example, although not shown, an adhesive sheet may be interposed or an adhesive may be applied between the composite sheet 32 and the ferrite sheet 31 in order to increase adhesion between the composite sheets 32 and the ferrite sheet 31.

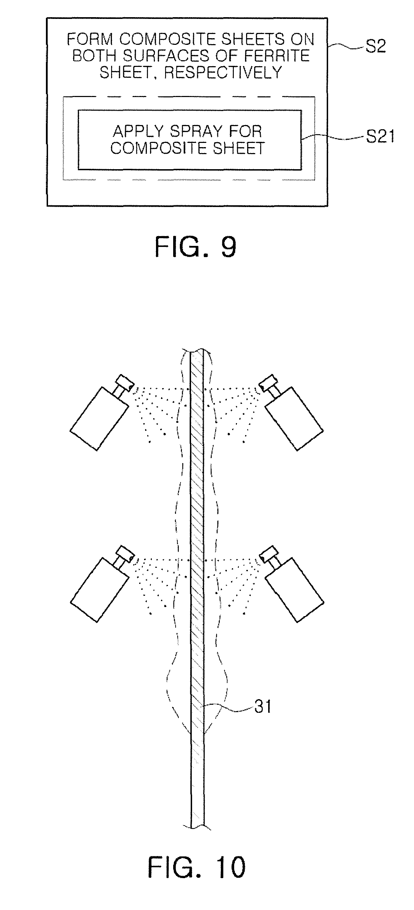

FIG. 9 is a flow chart illustrating a method of manufacturing a composite ferrite sheet according to another exemplary embodiment in the present disclosure; and FIG. 10 is a view illustrating the method of manufacturing the composite ferrite sheet of FIG. 9.

Referring to FIGS. 9 and 10, in the method of manufacturing a composite ferrite sheet according to the present exemplary embodiment, the operation (S2) of forming the composite sheets 32 on both surfaces of the ferrite sheet 31, respectively, may include an operation (S21) of applying a spray for the composite sheet 32 onto both surfaces of the ferrite sheet 31.

That is, in the method of manufacturing the composite ferrite sheet 30 according to the present exemplary embodiment, a solution for the composite sheet 32 may be sprayed onto both surfaces of the ferrite sheet 31 using a spraying scheme and be then hardened to form the ferrite sheet 31 and the composite sheets integrally with each other.

Meanwhile, various applications may be made. For example, although not shown, a process of pressing and compressing the applied composite sheets at both sides of the ferrite sheets 31 so that the metal powder particles contained in the composite sheets 32 and having the flake shape are substantially parallel to the ferrite sheet 31 may be added.

As described above, in the method of manufacturing the composite ferrite sheet 30 according to the present exemplary embodiment, the composite ferrite sheet 30 may be manufactured by various methods as long as the composite sheets 32 are stacked on both surfaces of the ferrite sheet 31, respectively.

In addition, in the method of manufacturing the composite ferrite sheet 30 according to the present exemplary embodiment, since the composite sheets 32 are bonded to both surfaces of the ferrite sheet 31, respectively, through a process of only disposing the composite sheets 32 on both surfaces of the ferrite sheet, respectively, the additional process of adhering the ferrite sheet 31 and the composite sheets 32 to each other may not be needed. Therefore, the number of processes of manufacturing the composite ferrite sheet 30 and costs required for manufacturing the composite ferrite sheet 30 may be decreased.

As set forth above, since the ferrite sheet 31 according to the exemplary embodiment in the present disclosure may have flexibility, it may be easily attached to an object having a curved surface or a rugged surface. Therefore, adhesion precision of the ferrite sheet 31 may be improved.

In addition, the composite ferrite sheet 30 according to exemplary embodiments in the present disclosure may be manufactured through the method of manufacturing the ferrite sheet 31 according to an exemplary embodiment in the present disclosure. Therefore, a process of forming a break line on a ferrite layer that has been performed in the related art may be omitted, and a process of forming a protecting sheet and a process of breaking the ferrite layer may be continuously performed, such that the number of manufacturing processes and a manufacturing cost may be decreased.

While exemplary embodiments have been shown and described above, it will be apparent to those skilled in the art that modifications and variations could be made without departing from the scope of the present invention as defined by the appended claims.

## Claims

1. A method of manufacturing a composite ferrite sheet (30), comprising:
preparing a ferrite sheet (31); and
forming composite sheets (32) having insulating properties on both surfaces of the ferrite sheet (31), wherein the forming of the composite sheets (32) includes:
applying slurry (33) for the composite sheets (32) to both surfaces of the ferrite sheet (31); and
rolling both surfaces of the ferrite sheet (31) and the slurry (33), to press and bond the slurry (33) to both surfaces of the ferrite sheet (31).

2. The method of manufacturing the composite ferrite sheet (30) of claim 1, wherein in the rolling of the ferrite sheet (31) and the slurry (33), one or more rollers (40) roll the slurry (33) and the ferrite sheet (31).

3. The method of manufacturing the composite ferrite sheet (30) of claim 1, wherein the slurry (33) for the composite sheets (32) is formed of a resin containing metal powder particles.

4. A method of manufacturing a composite ferrite sheet (30), comprising:
supplying a ferrite sheet (31) to a space between rollers (40);
supplying slurry (33) for a composite sheet to both surfaces of the ferrite sheet (31), before the ferrite sheet (31) enters the space between the rollers (40); and
applying the slurry (33) to the ferrite sheet and compressing the slurry (33) using the rollers (40).

## Patentansprüche

1. Verfahren zum Herstellen eines Ferritverbundblechs (30), Folgendes umfassend:
Vorbereiten eines Ferritblechs (31); und
Ausbilden von Verbundblechen (32) mit Isoliereigenschaften auf beiden Oberflächen des Ferritblechs (31), wobei das Ausbilden der Verbundbleche (32) Folgendes enthält:
Aufbringen von Aufschlämmung (33) für die Verbundbleche (32) auf beiden Oberflächen des Ferritblechs (31); und
Walzen beider Oberfächen des Ferritblechs (31) und der Aufschlämmung (33), um die Aufschlämmung (33) auf beide Oberflächen des Ferritblechs (31) zu pressen und mit diesen zu verbinden.

2. Verfahren zum Herstellen des Ferritverbundblechs (30) nach Anspruch 1, wobei beim Walzen des Ferritblechs (31) und der Aufschlämmung (33) eine oder mehrere Walzen (40) die Aufschlämmung (33) und das Ferritblech (31) walzen.

3. Verfahren zum Herstellen des Ferritverbundblechs (30) nach Anspruch 1, wobei die Aufschlämmung (33) für die Verbundbleche (32) aus einem Metallpulverteilchen enthaltenden Harz ausgebildet ist.

4. Verfahren zum Herstellen eines Ferritverbundblechs (30), Folgendes umfassend:
Bereitstellen eines Ferritblechs (31) an einen Raum zwischen Walzen (40);
Bereitstellen einer Aufschlämmung (33) für ein Verbundblech an beide Oberflächen des Ferritblechs (31), bevor das Ferritblech (31) in den Raum zwischen den Walzen (40) eintritt; und
Aufbringen der Aufschlämmung (33) auf das Ferritblech und Verdichten der Aufschlämmung (33) unter Verwendung der Walzen (40).

## Revendications

1. Procédé de fabrication d'une feuille de ferrite composite (30), comprenant :
la préparation d'une feuille de ferrite (31) ; et
la formation de feuilles composites (32) ayant des propriétés isolantes sur les deux surfaces de la feuille de ferrite (31), dans lequel la formation des feuilles composites (32) comporte :
l'application d'une suspension (33) pour les feuilles composites (32) aux deux surfaces de la feuille de ferrite (31) ; et
le laminage des deux surfaces de la feuille de ferrite (31) et de la suspension (33), pour appuyer et coller la suspension (33) aux deux surfaces de la feuille de ferrite (31).

2. Procédé de fabrication de la feuille de ferrite composite (30) selon la revendication 1, dans lequel dans le laminage de la feuille de ferrite (31) et de la suspension (33), un ou plusieurs cylindres (40) laminent la suspension (33) et la feuille de ferrite (31).

3. Procédé de fabrication de la feuille de ferrite composite (30) selon la revendication 1, dans lequel la suspension (33) pour les feuilles composites (32) est formée d'une résine contenant des particules de poudre de métal.

4. Procédé de fabrication d'une feuille de ferrite composite (30), comprenant :
la fourniture d'une feuille de ferrite (31) à un espace entre des cylindres (40) ;
la fourniture de suspension (33) pour une feuille composite aux deux surfaces de la feuille de ferrite (31), avant que la feuille de ferrite (31) n'entre dans l'espace entre les cylindres (40) ; et
l'application de la suspension (33) à la feuille de ferrite et la compression de la suspension (33) à l'aide des cylindres (40).
